Europäisches Patentamt

European Patent Office

Office européen des brevets

(11) Publication number: **0 218 241**
A2

# EUROPEAN PATENT APPLICATION

(21) Application number: 86113923.6

(22) Date of filing: 08.10.86

(51) Int. Cl.⁴: **H 04 N 9/78**, H 03 H 17/02

(30) Priority: 09.10.85 US 785881

(43) Date of publication of application: 15.04.87 Bulletin 87/16

(84) Designated Contracting States: DE GB IT

(71) Applicant: FAROUDJA LABORATORIES, INC., 946 Benicia Avenue, Sunnyvale California 94086 (US)

(72) Inventor: Faroudja, Yves C., 26595 Anacapa Drive, Los Altos Hills California 94022 (US)

(74) Representative: Meddle, Alan Leonard et al, FORRESTER & BOEHMERT Widenmayerstrasse 4/I, D-8000 München 22 (DE)

(54) Bi-dimensional comb filter.

(57) A multi-dimensional comb filter system for processing e.g. a quadrature modulated color television signal includes an input for receiving the signal; a first comb filter operating at the first period (such as the picture frame rate); and, a second comb filter operating at the second period (such as the picture line rate) connected in tandem with the first comb filter. A delay matching network is connected to the input and provides a delay to the original signal corresponding to the sum of the first period and the second period. A linear adder circuit is connected to the second comb filter ans to the delay matching network for combining in phase the delayed signal passing through the delay matching network and the signal put out by the second comb filter. The adder circuit includes an output for putting out the signal which has been separated by multi-dimensional comb filtering of the original signal without any process adaptivity or switching in response to the content of the original signal.

Docket No. H-687-P

## BIDIMENSIONAL COMB FILTER

### Background of the Invention

The present invention relates to processing apparatus for processing signals characterized by multiple time base. More particularly, the present invention relates to linear multi-dimensional processing of multiple time base signals such as quadrature modulated color television signals.

It is well known to separate chrominance and luminance information of a quadrature modulated color television signal by application of comb filtering techniques. Briefly, a 180 degree phase shift accompanies each successive line and frame of a color television signal encoded in accordance with the NTSC standard, and every two successive lines and frames of a color television signal encoded in accordance with the PAL standard. With such encoding arrangements, it is known to employ line delays and adders in order to achieve comb filters for separation of luminance and chrominance information.

In this regard, one illustrative teaching of the prior art is found in U.S. Patent No. 3,542,945 to Parker. The Parker patent teaches the use of line period (63.5 microsecond) delay lines to realize comb filters in a color television receiving apparatus. The Parker patent correctly notes that line averaging from the comb filtering technique results in loss of vertical color information resolution. A double comb filter operating at the line period was proposed in the Drummond et al. U.S. Patent No. 3,895,393 in order to remove certain artifacts from the picture, such as ringing, introduced by the presence of a single line period comb filter.

With the advent of picture frame stores, implemented with digital techniques and semiconductor frame store memories, comb filters operating at a frame rate have been realized.  Thus, today, comb filters employed to separate interleaved chroma and luminance spectra in a quadrature modulated color television system fall generally into two categories.  In the first class, the basic delay or memory element provides a single line period delay (NTSC or two such periods in PAL).  In the second class, the basic delay or memory element provides a single frame delay (NTSC or two frame delays in PAL).

While these comb filtering techniques provide superior separation of the chroma and luminance components, they have certain drawbacks and introduce unnatural artifacts into the resultant color television picture signal.  For example, the first class suffers from loss of luminance diagonal resolution, loss of chroma vertical resolution, and cross-color and cross-luminance patterns in certain picture conditions.  The second class suffers from chroma blurring with motion, positional errors in luminance high frequencies during picture motion, and occurrence of certain cross-color and cross-luminance patterns with certain motion speeds in the picture image.

Adaptive techniques to reduce the distortion introduced by comb filters during color signal and luminance signal transitions were proposed by the Rossi U.S. Patent No. 4,050,084 and by certain of the present applicant's prior patents, of which U.S. Patent No. 4,240,105 is representative. Recently, it has been proposed to extend adaptive switching techniques to switch between line comb filters and frame comb filters in order to reduce the known drawbacks associated with each type of filter. These adaptive techniques require complicated switching and control circuits in order to detect picture content transitions and switch to alternative processing techniques during the transition intervals.

Thus, a hitherto unsolved need has arisen for a signal processing technique for a multiple time base signal, such as quadrature modulated color televison, which minimizes distortion while operating linearly without any adaptivity or switching.

### Summary of the Invention with Objects

An improved multi-dimensional comb filter system separates a predetermined type of data such as luminance or chrominance from spectrally interleaved types of data contained in a periodically recurrent signal having a plurality of integral differing periods including at least a first period and a second period such as a quadrature modulated color television signal without any adaptivity or switching in response to conditions in the original signal.

The improved system includes an input for receiving the recurrent signal; a first comb filter operating at the first period (such as the picture frame rate); a second comb filter operating at the second period (such as the picture line rate); a delay matching network connected to the input for providing a delay to the signal corresponding to the sum of the first period and the second period; and a linear adder circuit connected to the second comb filter and to the delay matching network for combining in phase the delayed signal passing through the delay matching network and the data type put out by the second comb filter, the adder circuit including an output for putting out the data type which has been separated by multi-dimensional comb filtering of the original signal.

In one aspect of the invention the periodically recurrent signal comprises quadrature modulated color television in either the NTSC format or the PAL format.

In another aspect of the invention, the signal follows the NTSC format and the first period corresponds to one of a picture frame and a picture scanning line, and the second period corresponds to the other thereof, or the signal follows the PAL format and the first period corresponds to one of two picture frames and two picture scanning lines and the second period corresponds to the other thereof.

In a further aspect of the invention, the improved multi-dimensional comb filter system is specifically applied to separation of chrominance and luminance information in a quadrature modulated color television signal and includes an input for receiving the quadrature modulated color television signal; a first comb filter connected to the input and operating at a period related to one of picture frame and picture line, for separating a predetermined one of chrominance and luminance from the color television signal; a second comb filter connected to the first comb filter and operating at the period related to the other of picture frame and picture line, for further separating the predetermined one of chrominance and luminance; a delay matching network connected to the input for delay the color television signal corresponding to the predetermined one of chrominance and luminance put out by the second comb filter by providing a delay corresponding to picture frame and picture line periods; and a linear adder circuit connected to the second comb filter and to the delay matching network for combining in phase the delayed color television signal and the predetermined one of chrominance and luminance put out by the second comb filter said adder circuit including an output for putting out the predetermined one of chrominance and luminance which has been separated by multi-dimensional comb filtering of the color television signal.

In one more aspect of the invention, the first comb filter operates at the period of a picture frame and comprises a portion of the delay matching network by delaying the color television signal by a picture frame delay portion of the overall picture frame and line period delay required.

A general object of the present invention is to provide an improved multi-dimensional comb filter for separating a predetermined type of data such as luminance or chrominance from spectrally interleaved types of data contained in a periodically recurrent signal having a plurality of integral differing periods such as a quadrature modulated color television signal in a manner which overcomes limitations and drawbacks of the prior art.

A specific object of the present invention is to provide an improved, linearly operating bidimensional comb filter system for separating luminance and chrominance components of a quadrature modulated color television signal without switching or adaptivity to picture conditions and without introduction of unwanted picture artifacts.

Another object of the present invention is to provide a simple, bidimensional comb filter system for color television signal component processing which overcomes limitations and drawbacks of the prior art at low cost, and thereby lends itself to inclusion in mass produced consumer oriented television signal reception and display apparatus.

One further object of the present invention is to achieve a multi-dimensional comb filter system which advantageously utilizes low cost semiconductor digital conversion and storage elements.

These objects, advantages and features will be further understood from a consideration of the following detailed description of a preferred embodiment, presented in conjunction with the accompanying drawings.

## Brief Description of the Drawings

In the Drawings:

Fig. 1 is an overall block diagram of a multi-dimensional comb filter system in accordance with the principles of the present invention.

Fig. 2 is a detailed block diagram of one presently preferred embodiment of a multi-dimensional comb filter system for separation of luminance and chrominance components of a quadrature modulated color television picture signal in accordance with the principles of the present invention.

Fig. 3 is a graph of the spectrum put out by the comb filter system depicted in Fig. 2.

Fig. 4 is a block diagram of a color television signal encoder incorporating bidimensional comb filters of the type described in connection with Figs. 2 and 3.

Fig. 5 is a block diagram of a color television signal decoder incorporating bidimensional comb filters of the type described in connection with Figs. 2 and 3.

Detailed Description of Preferred Embodiments

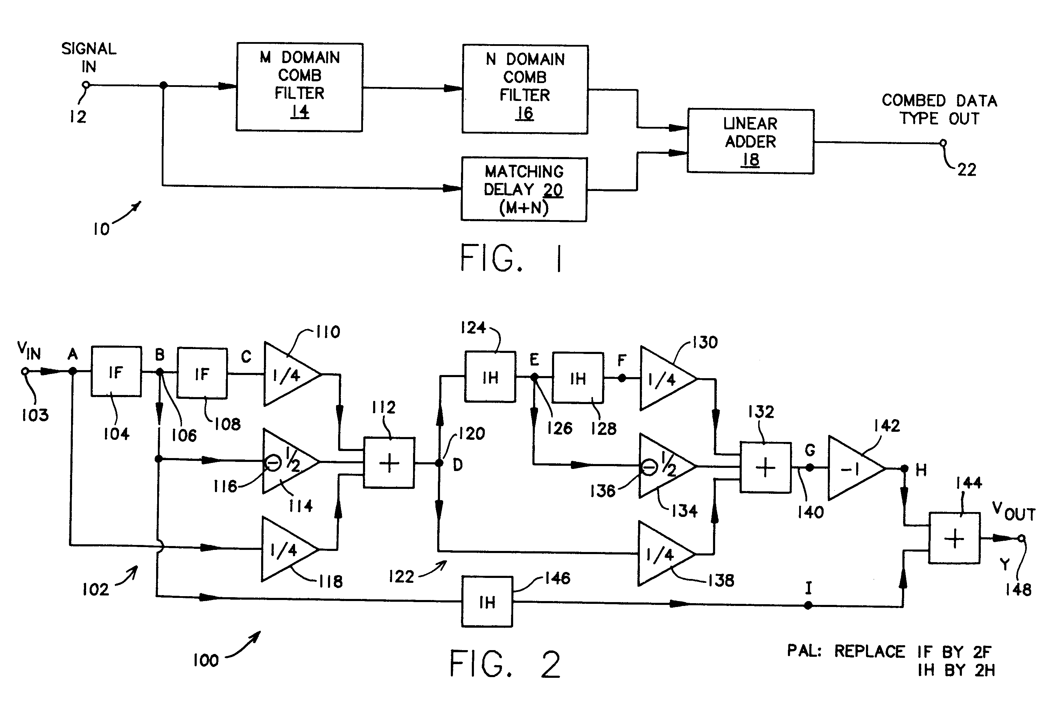

An overall bidimensional comb filter signal processing system 10 is depicted in Fig. 1. Therein, the system includes an input 12 for receiving a signal to be comb filtered. Presently, the preferred signal is quadrature modulated color television, in which chrominance information is interleaved in a high frequency portion of a luminance spectrum, centered about a chrominance subcarrier. Such a signal has at least two separate time bases, a picture frame rate (e.g. 1/30 Hz), and a line rate (e.g. 1/15,750 Hz). However, other signals having multiple time bases, such as radar signals having a sweep frequency and a pulse repetition frequency may be processed by comb filtering to remove or separate spectrally interleaved data or unwanted artifacts, in accordance with the principles of the present invention, as will be appreciated by those skilled in the art.

The signal at the input 12 enters an "M domain" comb filter 14. In the preferred application in color television signal processing the M domain corresponds to the period of a television picture frame, and at least one frame store is used in order to achieve a picture frame domain comb filter. With the advent of high speed (e.g. 20 MHz), low cost monolithic analog to digital converters and semiconductor memories, the M domain comb filter 14 is preferably implemented with digital techniques as are well known and available to those skilled in the art.

The output of the M domain comb filter 14 is connected to the input of an "N domain" comb filter 16. The N domain comb filter 16 corresponds to the period of a television scanning line in the preferred color television signal processing application.

The output of the N domain comb filter 16 enters one input of a linear adder circuit 18. Another input to the linear adder circuit 18 comes from a matching delay matrix 20 which delays the original signal precisely by the periods corresponding to M and N (frame and line periods in the preferred application). With an NTSC signal format, preferably M corresponds to one frame period and N corresponds to one line period. With a PAL signal format, M corresponds to two frame periods and N corresponds to two line periods.

An output 22 of the system 10 provides separated data of a type which has been selected and separated by the bidimensional comb filtering process, such as chrominance or luminance.

As is apparent by inspection of Fig. 1, the bidimensional comb filter system 10 provides a linear processing structure without any non-linear signal processing such as limiting, rectification, multiplication, switching as has characterized the approaches followed in the prior art. In addition, there is no adaptivity to signal conditions in the incoming signal. Thus, the implementing circuitry may be made very simply and at low prime cost, certainly far lower that the cost required to implement an adaptive processing system.

Turning to the presently preferred application, Fig. 2 illustrates a bidimensional comb filter system 100 for separation of luminance in a quadrature modulated color television picture signal. In the embodiment of Fig. 2, a first comb filter 102 operates at the picture frame rate. It includes a first frame delay 104 having a delay period of one frame (1/30 second). A node 106 is formed at the output of the first frame delay 104 and provides a three way signal branch. A first branch enters a second frame delay 108, the output of which is passed through an amplifier 110 having a one quarter unity gain factor. The output of the amplifier 110 enters a linear summing circuit 112.

A second branch from the node 106 passes through an amplifier 114 having a minus one half unity gain factor to the summing circuit 112. The reference numeral 116 points to the minus sign of the gain factor for the amplifier 114 to denote that it acts as an inverter in the instance of luminance separation. Should the system 100 be intended for the separation of chrominance, the minus sign 116 would be changed to a plus sign, and the amplifier 116 would operate with a plus one half unity gain factor.

An amplifier 118 having a one quarter unity gain factor has an input connected to the input 102 and an output connected to the summing circuit 112. The summing circuit 112 combines the three input values and puts out the sum thereof at an output node 120.

A second comb filter 122 operates at the picture line rate (1/15,750 second). The signal from the output node 120 passes through a one line delay 124 to reach a node 126 which provides a two way branch of the resultant, delayed signal. A first branch passes through a second one line delay 128 and a one quarter gain factor amplifier 130 to reach a second summing circuit 132.

A second branch from the node 126 passes through a minus one half gain factor amplifier 134 to the second summing circuit 132. As with the amplifier 114, the reference numeral 136 to the minus sign denotes that the amplifier 114 acts as a signal inverter in the instance of luminance separation. It would not be an inverter if chrominance is to be separated. Thus, in the system 100, the signs 116 and 136 are both minus for luminance separation, and plus for chrominance separation.

The signal from the output 120 of the first comb filter 102 passes through one quarter unity gain factor amplifier 138 and enters the second summing circuit 132 wherein all three signal components are combined in proper phase relation, and the resultant sum is put out at an output node 140.

The signal at the output node 140 is passed through a unity gain inverter 142 and combined in a third summing circuit 144 with a one frame delayed signal from the third branch of the node 106 of the first comb filter 102 which has been further delayed by the period of one line by first passing through a line delay 146. Thus, in the system 100 depicted in Fig. 2, it will be appreciated that delay matching is provided by the use of the first frame delay 104 and a third one line delay 146.

If the system 100 is to be used for separation of luminance (chrominance) of a PAL format television signal, the delays provided by the frame delays 104 and 108 correspond to two frame periods, and the delays provided by the line delays 124, 128 and 146 correspond to two line periods.

In the case of stationary picture images, the luminance information at A (input 102) is the same as the information at B (the node 106) and is also the same as the information at C (output of the second frame delay 108). The output D at the node 120 is equal to the following expression:

$$D = \frac{A+C}{4} + \frac{-B}{2} = 0$$

When the output D of the first comb filter 102 is zero, no signal enters the second comb filter 122, and the output thereof H is likewise zero. Thus, nothing is added to the original picture at the third adding circuit 144, and the system output at the node 148 is exactly the same as the signal at the input 102, except for being delayed by the periods of one frame and one line. There is no degradation in the luminance picture for stationary images.

In the case of moving vertical lines, the output D of the first comb filter 102 is other than zero for luminance. However, in the line period domain, the signal D is equal to the signal E which is equal to the signal F. The output signal G at the node 140 is equal to the following expression:

$$G = \frac{D+F}{4} - \frac{E}{2} = 0$$

Thus, there is no degradation of the combed luminance component in the case of moving vertical lines.

In the case of moving diagonal luminance transitions in the picture content, the output of the first comb filter 102 is unequal to zero and the signal degradation introduced by the system 100 is equivalent in performance to that of the two line comb 122 alone when the speed of motion of the transitions is such that D = -1 (which is the worst case), and a linear combination of the two line comb 122 and the delay line 146 when the transition speed is between -1 and zero. Thus, in the worst case, the luminance transition becomes averaged over a few lines, with some slight blurring.

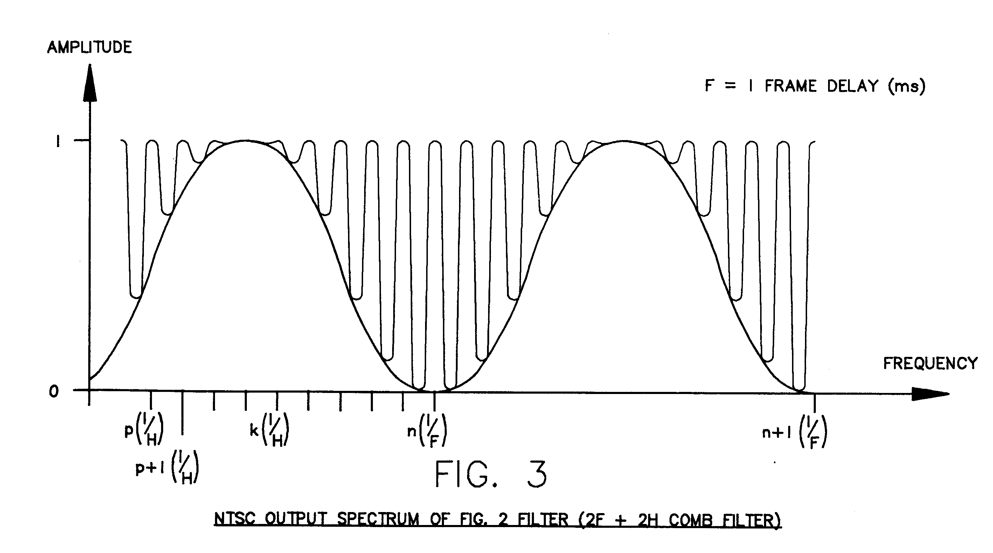

The comb filtering action provided by the tandem arrangement of frame and line comb filters in the system 100 is depicted by the output waveform diagram of Fig. 3. Therein, the luminance components are maximally present at each even multiple of the line frequency n and are minimally present at the odd multiples thereof. The low frequency sine wave corresponds to the frame rate and shows how the frame rate is used to enhance the comb filtering action of the system 100.

It will be appreciated by those skilled in the art that the ordering of the frame comb filter 102 and the line comb filter 122 in the tandem system 100 is immaterial, since there is no interactivity between the two filters. However, some practical cost savings are presently realized by placing the frame filter 102 before the line filter 122, so that the first delay 104 of the filter 102 may also provide the required one frame delay portion of the overall original signal delay (one frame and one line). This arrangement requires only one additional line delay 146 and results in a less expensive implementation than if an additional frame delay were required, as frame delays are presently more expensive than line delays.

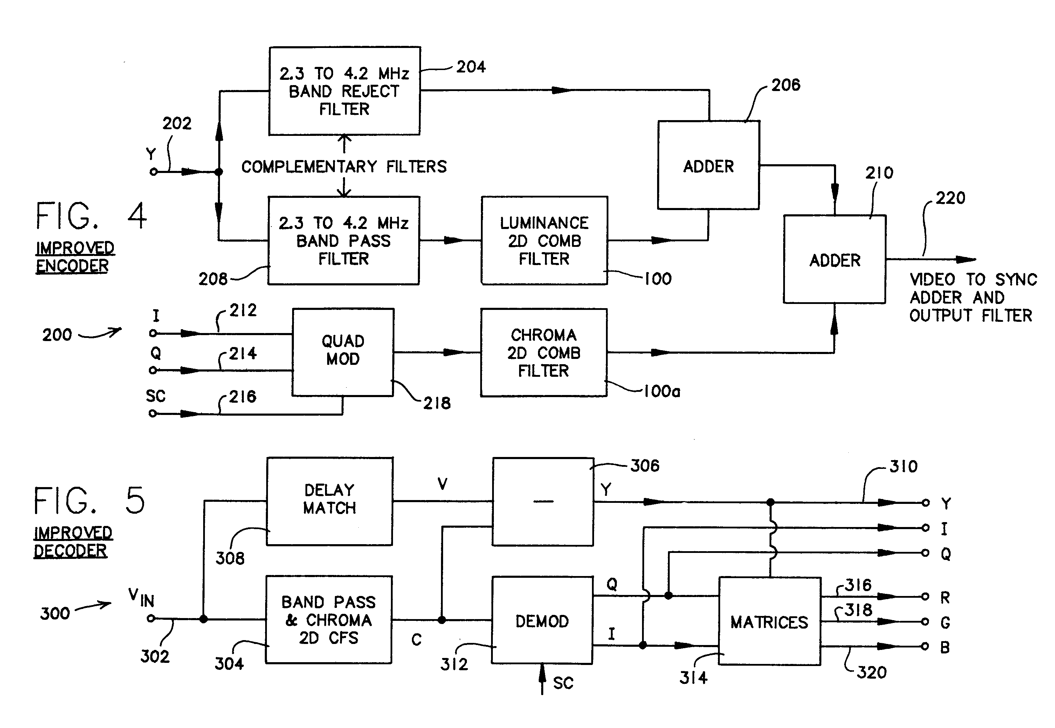

A practical example of an improved color encoder 200 for a quadrature modulated color television picture signal system is depicted in overview in Fig. 4. Therein, a luminance signal at an input 202 is split into two paths, a first path through a 2.3 to

4.2 MHz band reject filter to an adder 206, and a second path through a 2.3 to 4.2 MHz band pass filter 208 and the luminance bidimensional comb filter 100 of Figs. 2 and 3 to the adder 206.

Color components I and Q and color subcarrier, on lines 212, 214 and 216 respectively, enter a quadrature modulator 218 and pass through a chrominance bidimensional comb filter system 100a (in which the signs 116 and 136 have been changed from minus to plus) to the adder 210. This encoder 200 puts out a color picture signal in which both luminance and chroma components have been enhanced by bidimensional comb filtering in accordance with the present invention before these components have been combined together.

Fig. 5 illustrates an improved low cost decoder 300 for color television, suitable for inclusion in color television receiving apparatus intended for the consumer. In the decoder 300 the color television picture signal enters at an input 302 and passes through a chroma band pass and bidimensional comb filter 304. This filter 304 includes the elements 208 and 100a found in the Fig. 4 encoder. The separated chrominance component exiting the filter 304 is passed into a subtractor circuit 306 where it is subtracted from the color signal which has been suitably delayed by a delay matching circuit 308. The resultant difference is luminance which is put out on a luminance output line 310.

The combed chroma component is then subjected to demodulation in a chroma demodulator 312 in order to recover the I and Q phase components making up the color signal. These phase

components, together with luminance, are then passed through conventional color matrices 314 in order to recover the red (R), green (G) and blue (B) color components which are put out on lines 316, 318 and 320 respectively.

While the apparatus and methods of the present invention have been summarized and explained by an illustrative application in bidimensional linear comb filter processing of quadrature modulated color television signals and components thereof, it will be readily apparent to those skilled in the art that many widely varying embodiments and applications are within the teaching and scope of the present invention, and that the color television examples presented herein are by way of illustration only and are not intended to be limiting of the scope of the present invention, as more precisely defined by the following claims.

I claim:

1.  An improved multi-dimensional comb filter system for separation of a predetermined type of data from spectrally interleaved types of data contained in a periodically recurrent signal having a plurality of integral differing periods including at least a first period and a second period, said system including:

an input for receiving said recurrent signal having said spectrally interleaved data types;

first comb filter means operating at said first period and connected to said input for first separation processing of said data type from the data types contained in said signal;

second comb filter means operating at said second period and connected to said first comb filter means for second separation processing of said data type;

delay matching means connected to said input for providing a delay to the signal corresponding to the sum of the first period and the second period;

linear adder means connected to said second comb filter means and to said delay matching means for combining in phase the delayed signal passing through said delay matching means and the data type put out by the second comb filter means, said adder means including an output for putting out said data type which has been separated by multi-dimensional comb filtering of the signal.

2.  The system set forth in claim 1 wherein the periodically recurrent signal comprises quadrature modulated color television.

3. The system set forth in claim 2 wherein the color television signal follows the NTSC format and the first period corresponds to one of a picture frame and a picture scanning line, and the second period corresponds to the other thereof.

4. The system set forth in claim 2 wherein the color television signal follows the PAL format and the first period corresponds to one of two picture frames and two picture scanning lines, and the second period corresponds to the other thereof.

5. The system set forth in claim 2 wherein the predetermined data type comprises chrominance.

6. The system set forth in claim 2 wherein the predetermined data type comprises luminance.

7. An improved multi-dimensional comb filter system for separation of chrominance and luminance information in a quadrature modulated color television signal comprising:

an input for receiving the quadrature modulated color television signal;

first comb filter means connected to the input and operating at a period related to one of picture frame and picture line, for separating a predetermined one of chrominance and luminance from the color television signal,

second comb filter means connected to the first comb filter means and operating at the period related to the other of picture frame and picture line, for further separating the predetermined one of chrominance and luminance,

delay matching means connected to the input for delay the color television signal corresponding to the predetermined one of chrominance and luminance put out by the second comb filter means by providing a delay corresponding to picture frame and picture line periods,

linear adder means connected to the second comb filter means and to the delay matching means for combining in phase the delayed color television signal and the predetermined one of chrominance and luminance put out by the second comb filter means, said adder means including an output for putting out said predetermined one of chrominance and luminance which has been separated by multi-dimensional comb filtering of the color television signal.

8. The system set forth in claim 7 wherein the predetermined one is chrominance.

9. The system set forth in claim 7 wherein the predetermined one is luminance.

10. The system set forth in claim 7 wherein said first comb filter means inherently provides a portion of the delay required to be provided by the delay matching means.

11. The system set forth in claim 10 wherein said first comb filter means operates at the period of a picture frame and comprises a portion of the delay matching means by delaying the analog color television signal by a picture frame delay portion of the overall picture frame and line period delay required.

12. The system set forth in claim 7 wherein the analog color television signal is in accordance with the NTSC format and the periods of the first and second comb filter means which are related to picture frame and picture line, are respectively periods corresponding to one picture frame and one picture line.

13. The system set forth in claim 7 wherein the analog color television signal is in accordance with the PAL format and the periods of the first and second comb filter means which are related to picture frame and picture line, are respectively periods corresponding to two picture frames and two picture lines.

14. An improved bi-dimensional comb filter system for separating luminance information in a quadrature modulated color television signal comprising:

first comb filter means operating at the period related to a picture frame and including an input for receiving the quadrature modulated color television signal, a first summing junction, a first n frame delay between the input and a first node, a second n frame delay between the first node and a first quarter amplitude gain factor amplifier having an output connected to the first summing junction, a first minus one half amplitude gain factor amplifier having an input connected to the first node and an output connected to the first summing junction, a second quarter amplitude gain factor amplifier having an input connected to the input and an output connected to the first summing junction (where n equals a whole integer),

second comb filter means operating at the period related to a picture line and being connected to the first summing junction, the second comb filter means including: a second summing junction, a first n line delay between the output of the first summing junction and a third node, a second n line delay between the third node and a third quarter amplitude gain factor amplifier having an output connected to the second summing junction, a second minus one half amplitude gain factor amplifier having an input connected to the third node and an output connected to the second summing junction, a fourth quarter amplitude gain factor amplifier having an input connected to the output of the first summing junction and an output connected to the second summing junction (where n equals the whole integer),

a third summing junction providing an output for putting out the bi-dimensionally combed chrominance,

a minus unity gain amplifier connected between the output of the second summing junction and the input of the third summing junction, and

an n line delay connected between the first node and the input of the third summing junction.

15. The system set forth in claim 14 wherein the quadrature modulated color television signal is in accordance with the NTSC format and n equals unity.

16. The system set forth in claim 14 wherein the quadrature modulated color television signal is in accordance with the PAL format and n equals two.

17. An improved bi-dimensional comb filter system for separating chrominance information in a quadrature modulated color television signal comprising:

first comb filter means operating at the period related to a picture frame and including an input for receiving the quadrature modulated color television signal, a first summing junction, a first n frame delay between the input and a first node, a second n frame delay between the first node and a first quarter amplitude gain factor amplifier having an output connected to the first summing junction, a first one half amplitude gain factor amplifier having an input connected to the first node and an output connected to the first summing junction, a second quarter amplitude gain factor amplifier having an input connected to the input and an output connected to the first summing junction (where n equals a whole integer),

second comb filter means operating at the period related to a picture line and being connected to the first summing junction, the second comb filter means including: a second summing junction, a first n line delay between the output of the first summing junction and a third node, a second n line delay between the third node and a third quarter amplitude gain factor amplifier having an output connected to the second summing junction, a second one half amplitude gain factor amplifier having an input connected to the third node and an output connected to the second summing junction, a fourth quarter amplitude gain factor amplifier having an input connected to the output of the first summing junction and an output connected to the second summing junction (where n equals the whole integer),

a third summing junction providing an output for putting out the bi-dimensionally combed chrominance,

a minus unity gain amplifier connected between the output of the second summing junction and the input of the third summing junction, and

an n line delay connected between the first node and the input of the third summing junction.

18.   The system set forth in claim 17 wherein the quadrature modulated color television signal is in accordance with the NTSC format and n equals unity.

19.   The system set forth in claim 17 wherein the quadrature modulated color television signal is in accordance with the PAL format and n equals two.

FIG. I

FIG. 2

0 218 241

PAL: REPLACE IF BY 2F
IH BY 2H

FIG. 3

NTSC OUTPUT SPECTRUM OF FIG. 2 FILTER (2F + 2H COMB FILTER)

AMPLITUDE

F = 1 FRAME DELAY (ms)

FREQUENCY

$p\left(\dfrac{1}{H}\right)$

$p+1\left(\dfrac{1}{H}\right)$

$k\left(\dfrac{1}{H}\right)$

$n\left(\dfrac{1}{F}\right)$

$n+1\left(\dfrac{1}{F}\right)$

2/3

0 218 241

0 218 241

FIG. 4

__IMPROVED ENCODER__

200

Y 202

I 212
Q 214
SC 216

2.3 TO 4.2 MHz BAND REJECT FILTER — 204

COMPLEMENTARY FILTERS

2.3 TO 4.2 MHz BAND PASS FILTER — 208

LUMINANCE 2D COMB FILTER — 100

QUAD MOD — 218

CHROMA 2D COMB FILTER — 100a

ADDER — 206

ADDER — 210

220

VIDEO TO SYNC ADDER AND OUTPUT FILTER

FIG. 5

__IMPROVED DECODER__

300

V_IN 302

BAND PASS & CHROMA 2D CFS — 304

DELAY MATCH — 308

DEMOD — 312

SC

V

C

Y — 306

Q
I

— — 310

MATRICES — 314

316
318
320

Y
I
Q
R
G
B